# FASCICULE DE BREVET EUROPEEN

(11) **EP 1 407 449 B1**
(45) Date de publication et mention de la délivrance du brevet: **15.03.2006**
(21) Numéro de dépôt: 02764938.3
(22) Date de dépôt: 02.07.2002
(51) Int. Cl.: G11B 5/74, G11B 5/855, G11B 5/82, G11B 5/09

(54) **SUPPORT DE STOCKAGE D'INFORMATIONS A RESEAU DE PLOTS AIMANTES LATERALEMENT ET PROCEDE DE FABRICATION DE CE SUPPORT.**
DATENSPEICHERMEDIUM MIT SEITLICH MAGNETISIERTEN KONTAKTSTELLEN UND HERSTELLUNGSVERFAHREN
DATA STORAGE MEDIUM WITH LATERALLY MAGNETISED PADS AND METHOD FOR MAKING SAME

(30) Priorité: 04.07.2001 FR 0108869
(43) Date de publication de la demande: 14.04.2004
(73) Titulaire: COMMISSARIAT A L'ENERGIE ATOMIQUE, 75752 Paris Cédex 15 (FR)
(72) Inventeur: RODMACQ, Bernard, F-38113 VEUREY-VOROIZE (FR); LANDIS, Stéphane, 98110 La Tour du Pin (FR); DIENY, Bernard, F-38250 LANS en VERCORS (FR)
(74) Mandataire: Poulin, Gérard
(86) Numéro de dépôt international: PCT/FR2002/002299
(87) Numéro de publication internationale: WO 2003/005349

(56) Documents cités:
- EP-A- 0 110 730
- EP-A- 0 452 876
- US-A- 5 536 585
- US-A- 5 603 766
- PATENT ABSTRACTS OF JAPAN vol. 018, no. 519 (P-1807), 29 septembre 1994 (1994-09-29) -& JP 06 176343 A (SUMITOMO METAL IND LTD), 24 juin 1994 (1994-06-24)
- FERNANDEZ A ET AL: "MAGNETIC FORCE MICROSCOPY OF SINGLE-DOMAIN COBALT DOTS PATTERNED USING INTERFERENCE LITHOGRAPHY" IEEE TRANSACTIONS ON MAGNETICS, IEEE INC. NEW YORK, US, vol. 32, no. 5, 1 septembre 1996 (1996-09-01), pages 4472-4474, XP000634041 ISSN: 0018-9464
- MATSUYAMA K ET AL: "Magnetic properties of nanostructured wires deposited on the side edge of patterned thin film" 44TH ANNUAL CONFERENCE ON MAGNETISM AND MAGNETIC MATERIALS, SAN JOSE, CA, USA, 15-18 NOV. 1999, vol. 87, no. 9, pt.1-3, pages 4724-4726, XP002193457 Journal of Applied Physics, 1 May 2000, AIP, USA ISSN: 0021-8979 cité dans la demande
- CHOU S Y: "PATTERNED MAGNETIC NANOSTRUCTURES AND QUANTIZED MAGNETIC DISKS" PROCEEDINGS OF THE IEEE, IEEE. NEW YORK, US, vol. 85, no. 4, 1 avril 1997 (1997-04-01), pages 652-671, XP000698884 ISSN: 0018-9219
- DEVOLDER T ET AL: "ION BEAM-INDUCED MAGNETIC PATTERNING AT THE SUB-0.1 MUM LEVEL STRUCTURATION MAGNETIQUE PAR FAISCEAUX D'IONS AUX ECHELLES INFERIEURES A 0,1 MUM" COMPTES RENDUS DES SEANCES DE L'ACADEMIE DES SCIENCES. SERIE II:MECANIQUE, PHYSIQUE, CHIMIE, SCIENCES DE LA TERRE, SCIENCES DE L'UNIVERS, GAUTHIER-VILLARS. MONTREUIL, FR, vol. 327, no. 9, septembre 1999 (1999-09), pages 915-923, XP000920122 ISSN: 1251-8069
- HE L ET AL: "SIZE AND SHAPE EFFECTS OF PATTERNED POLYCRYSTALLINE ISLANDS" IEEE TRANSACTIONS ON MAGNETICS, IEEE INC. NEW YORK, US, vol. 35, no. 5, PART 2, septembre 1999 (1999-09), pages 3508-3510, XP000867980 ISSN: 0018-9464

## Description

### DOMAINE TECHNIQUE

La présente invention concerne un support de stockage d'informations (« information storage medium ») ainsi qu'un procédé de fabrication de ce support.

Elle s'applique notamment aux disques durs pour les ordinateurs.

### ETAT DE LA TECHNIQUE ANTERIEURE

Un support, ou mémoire, de stockage d'informations est actuellement constitué d'une couche mince et continue de grains ferromagnétiques. L'aimantation de ces grains est dirigée dans le plan de la couche et chaque « bit » d'information est constitué de plusieurs grains dont toutes les aimantations sont parallèles à une même direction.

Si cette direction est définie comme correspondant à un « zéro », l'aimantation opposée sera définie comme correspondant à un « un » en notation binaire. Une tête de lecture/écriture, en volant au dessus de la couche de grains ferromagnétiques*,* peut donc coder des informations en créant localement un champ magnétique susceptible d'orienter l'aimantation de chaque « bit » dans l'une ou l'autre direction.

La densité des informations stockées sur un cel support est limitée par la taille des « bits » et par les zones de transition. Afin d'augmenter cette densité, diverses solutions ont déjà été envisagées:
- utiliser un matériau magnétique continu dont l'aimantation est perpendiculaire au plan de la couche,
- utiliser un support « discret », c'est-à-dire un réseau (« array ») de plots (« dots ») magnétiques indépendants les uns des autres, chaque plot étant monodomaine, c'est-à-dire correspondant à un seul domaine magnétique, ce dernier correspondant lui-même à un bit d'information.

À ce sujet, on se reportera au document suivant :
[1] S.Y. Chou, P.R. Krauss, L. Kong, « Nanolithographically defined magnetic structures and quantum magnetic disk », Journal of Applied Physics 79, 6101 (1996).

Dans le cas où l'aimantation du matériau magnétique est parallèle au plan du réseau de plots (aimantation planaire), on peut rendre chaque plot monodomaine en ajustant sa forme (ellipse par exemple), afin de ne favoriser que deux directions d'aimantation. Mais un tel réseau est plus compliqué à fabriquer qu'un réseau de plots de forme carrée ou rectangulaire.

Dans le cas où l'aimantation du matériau magnétique est perpendiculaire au plan du réseau, l'état monodomaine est plus facile à obtenir, et des plots à section carrée ou circulaire peuvent être utilisés.

Néanmoins, le signal détecté par la tête de lecture est en principe plus faible car de tels matériaux à aimantation perpendiculaire sont généralement des alliages ou des multicouches à base d'un élément magnétique et d'un élément non magnétique, ceci réduisant d'autant le champ créé au voisinage des plots.

De plus, dans le cas d'une multicouche, on sait que le nombre de répétitions ne peut être augmenté indéfiniment (afin d'augmenter le champ rayonné) car l'aimantation tend à s'orienter progressivement dans le plan sous l'effet du champ démagnétisant.

En outre, JP-A-06176343 divulgue un support de stockage selon le préambule de la revendication 1.

### EXPOSÉ DE L'INVENTION

La présente invention propose un support de stockage d'informations, comprenant un réseau de plots magnétiques, ce support ayant de bonnes performances tant pour la lecture que pour l'écriture des informations.

De façon précise, la présente invention a pour objet un support de stockage d'informations, ce support étant caractérisé en ce qu'il comprend un réseau de plots de dimensions submicroniques, ce réseau étant formé sur un substrat, chaque plot contenant au moins un domaine magnétique qui a une direction d'aimantation et correspond à un bit défini par cette direction d'aimantation, ce domaine magnétique étant formé par une couche mince d'au moins un matériau magnétique qui recouvre latéralement ce plot.

Selon un mode de réalisation préféré du support objet de l'invention, la direction d'aimantation est perpendiculaire au plan du réseau de plots.

L'invention concerne aussi un procédé de fabrication du support de stockage d'informations, objet de l'invention, dans lequel on dépose le matériau magnétique sur les plots en envoyant sur ces derniers un premier flux d'atomes de ce matériau sous une incidence oblique par rapport à la normale au plan du réseau, chaque plot faisant ombrage au plot qui le suit dans le sens du premier flux, et l'on neutralise le signal magnétique résultant du matériau magnétique déposé au sommet des plots et au fond des tranchées séparant des rangées de plots, pour que seule subsiste un signal magnétique engendré par le matériau déposé sur le flanc des plots.

Le matériau magnétique peut être choisi dans le groupe comprenant le fer, le nickel, le cobalt, les alliages de ces derniers et les matériaux magnétiques à forte aimantation, ou l'un des matériaux de ce groupe, auquel on ajoute un ou une pluralité d'autres éléments, en quantité variable, par exemple choisi parmi le chrome, le tantale, le platine, le molybdène et le terbium, ces éléments permettant d'ajuster les propriétés magnétiques de la couche mince, telles que la coercivité, l'aimantation à saturation et l'anisotropie magnétique de cette couche mince.

Selon un mode de mise en oeuvre particulier du procédé objet de l'invention, une résine recouvre le sommet des plots avant le dépôt du matériau magnétique et l'on élimine cette résine après avoir déposé ce matériau magnétique, pour obtenir ainsi un premier dépôt sur les flancs des plots.

Dans ce cas, on peut envoyer sur le réseau de plots un deuxième flux d'atomes d'un matériau de neutralisation en même temps que l'on envoie le premier flux et sous une incidence normale au plan du réseau ou sous une incidence oblique par rapport à la normale au plan du réseau, avec un angle d'incidence opposé à celui du premier flux par rapport à cette normale, l'intensité du deuxième flux et le matériau de neutralisation étant choisis pour que l'alliage ainsi formé au fond des tranchées avec le matériau magnétique ait des propriétés magnétiques différentes de celles du premier dépôt obtenu sur les flancs des plots.

Dans la présente invention, on peut envoyer le premier flux et au moins un deuxième flux d'atomes d'un matériau magnétique sur les plots, sous des incidences obliques par rapport à la normale au plan du réseau, pour former des dépôts magnétiques sur une pluralité de flancs de chaque plot.

Selon un autre mode de mise en oeuvre particulier du procédé objet de l'invention, on élimine le matériau magnétique déposé sur le sommet des plots et au fond des tranchées, cette élimination résultant par exemple d'une abrasion ionique sous une incidence oblique par rapport à la normale au plan du réseau, avec un angle d'incidence opposé à celui du premier flux.

Selon un autre mode de mise en oeuvre particulier du procédé objet de l'invention, on envoie un deuxième flux d'atomes, en même temps que le premier flux, sous un incidence oblique par rapport au plan du réseau, avec un angle d'incidence opposé à celui du premier flux, l'intensité et la nature des atomes du deuxième flux étant aptes à conduire, avec le premier flux, à la formation d'un alliage non magnétique au sommet des plots et au fond des tranchées.

Dans ce cas, après avoir déposé les atomes des premier et deuxième flux,
- on intervertit ces premier et deuxième flux et l'on envoie les flux ainsi intervertis sur les plots ou
- on fait tourner le réseau de 180° autour de la normale au plan du réseau et l'on envoie à nouveau les premier et deuxième flux,

afin d'obtenir un dépôt des atomes des premier et deuxième flux sur deux flancs opposés de chaque plot.

Dans la présente invention, on peut
- former la couche mince en présence d'un champ magnétique extérieur ou
- après avoir formé la couche mince, traiter thermiquement cette couche mince en présence d'un champ magnétique extérieur, ou
- on effectue un dépôt d'une couche d'un matériau antiferromagnétique au-dessus ou au-dessous de la couche mince,

afin d'induire un axe d'anisotropie magnétique dans le plan de cette couche mince.

Dans l'invention, les plots peuvent avoir une section transversale circulaire ou elliptique parallèlement au plan du réseau, la couche mince formée latéralement sur chaque plot ayant ainsi un gradient latéral d'épaisseur, et l'on utilise ce gradient pour induire un axe d'anisotropie magnétique perpendiculaire au plan du réseau.

Dans l'invention, on peut former en outre une couche protectrice sur toute la surface du réseau puis effectuer un planage de cette surface ainsi pourvue de la couche protectrice, afin d'éliminer tout relief.

Certes, la technique de dépôt de matière sous incidence oblique est connue mais n'a jamais été utilisée pour la fabrication de structures du genre de celles qui font l'objet de la présente invention.

Dans le domaine des structures magnétiques, le dépôt sous incidence oblique a seulement été utilisé pour déposer un matériau magnétique sur le flanc d'une unique ligne en silicium gravé. A ce sujet, on se reportera au document suivant :
[2] K. Matsuyama, S. Komatsu, Y. Nozaki, « Magnetic properties of nanostructures wires deposited on the side edge of patterned thin film », Journal of Applied Physics 87, 4724 (2000).

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- la figure 1 est une vue en perspective schématique et partielle d'un mode de réalisation particulier du support magnétique de stockage d'informations, objet de l'invention,
- les figures 2A et 2B illustrent schématiquement des procédés de fabrication de ce support magnétique,
- la figure 3 est une vue de dessus schématique d'un plot à section circulaire faisant partie d'un support magnétique conforme à l'invention,
- la figure 4 est une représentation schématique de différents cas considérés pour le calcul de la composante, suivant un axe normal au plan d'un réseau de plots d'un support conforme à l'invention, du champ magnétique existant au-dessus de ce réseau, et
- la figure 5 montre les variations de cette composante en fonction de la distance au centre d'un plot, dans ces différents cas considérés.

### EXPOSÉ DÉTAILLÉ DE MODES DE RÉALISATION PARTICULIERS

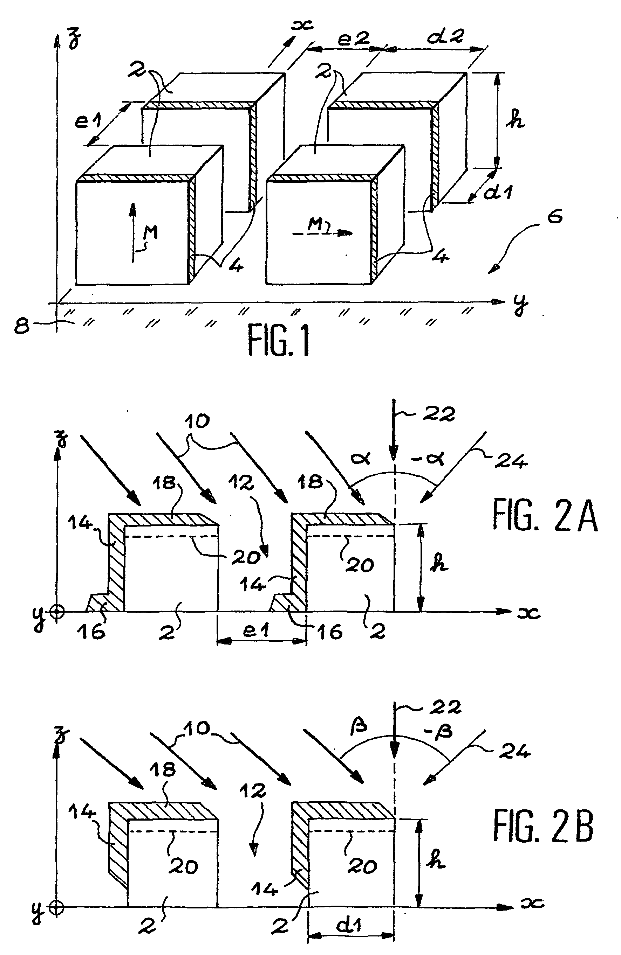

La figure 1 est une vue en perspective schématique et partielle d'un mode de réalisation particulier d'une mémoire magnétique de stockage d'informations, qui est faite à partir d'un réseau de plots submicroniques 2.

Ces plots 2 sont par exemple en silicium, en verre, en aluminium ou en résine polymère durcie.

Les dimensions des plots 2 ainsi que les espaces entre plots adjacents sont dans l'intervalle allant de 10 nm à 500 nm.

Dans cet exemple le réseau de plots comprend des lignes et des colonnes de plots parallélépipédiques, l'espace entre deux lignes adjacentes est noté e1, l'espace entre deux colonnes adjacentes est noté e2, chaque plot a une hauteur h, une profondeur d1, comptée parallèlement aux colonnes, et une largeur d2, comptée parallèlement aux lignes, et chacune de ces dimensions e1, e2, h, d1 et d2 appartient à l'intervalle mentionné plus haut. Si l'on utilisait des plots à section transversale circulaire (respectivement elliptique), le diamètre (respectivement le grand axe et le petit axe) de ces plots appartiendrait à cet intervalle.

Sur chacun des plots 2 on a déposé une couche mince unique, faite d'un matériau magnétique classique (par exemple un matériau ferromagnétique), sous incidence oblique.

Un but de la présente invention est la réalisation d'un dépôt magnétique uniquement sur un flanc ou une pluralité de flancs des plots. Dans l'exemple de la figure 1, ce dépôt magnétique 4 est formé sur un seul flanc des plots 2.

On définit un repère (x, y, z) dans lequel chacun des axes x, y, z est perpendiculaire aux deux autres. Le plan (x, y) est le plan du réseau, c'est-à-dire le plan de la surface 6 du substrat 8 à partir duquel on a formé les plots 2. Les lignes du réseau sont parallèles à l'axe y et ses colonnes, à l'axe x.

L'axe z est perpendiculaire à ce plan (x, y) et le plan (x, z) est le plan d'incidence du flux de matériau à partir duquel on a formé le dépôt 4 sur chaque plot, c'est-à-dire le plan auquel ce flux est parallèle.

Il en résulte que l'aimantation du dépôt 4 formé sur le flanc de chacun des plots 2 est parallèle au plan (y, z) dans le cas d'un matériau magnétique à aimantation planaire. Cette aimantation, notée M sur la figure 1, peut être dirigée selon l'axe y ou selon l'axe z.

De plus, si l'on parvient à orienter l'axe d'anisotropie magnétique selon l'axe z, toujours parallèlement au plan (y, z), on obtient alors l'équivalent d'un matériau à aimantation perpendiculaire.

Toutefois, avec une telle orientation, un support de stockage d'informations conforme à l'invention présente un signal magnétique plus élevé (car le matériau magnétique utilisé est pur et son épaisseur totale n'est pas limitée) et plus localisé spatialement qu'un support de stockage d'informations utilisant un matériau à aimantation perpendiculaire.

Un tel support conforme à l'invention présente en outre une plus grande simplicité de dépôt de la couche magnétique ainsi qu'une tenue thermique supérieure, ce qui permet une totale compatibilité avec les procédés techniques classiques de fabrication de supports de stockage d'informations.

On explique dans ce qui suit un procédé de fabrication d'un support de stockage d'informations conformément à l'invention.
1) On utilise un réseau de plots de section carrée, rectangulaire, circulaire ou elliptique, ce réseau étant obtenu par un procédé classique de nanolithographie ou par la technique de nano-imprint à partir d'un substrat, Le substrat est par exemple en silicium, en verre, en aluminium ou en résine polymère durcie.
2) Pour former les dépôts magnétiques, on utilise une technique classique de dépôt de couches minces métalliques, par exemple la pulvérisation cathodique ou l'évaporation sous vide.
3) L'angle d'incidence du flux 10 (figures 2A et 2B) d'atomes du matériau magnétique par rapport à la normale (axe z) au plan (x, y) du réseau de plots 2 vaut environ 45° et ce flux 10 est parallèle au plan (x, z) qui forme le plan d'incidence. En outre, ce flux est collimaté (par des moyens non représentés) de façon à être le moins divergent possible.
4) L'angle d'incidence, la hauteur h des plots 2 et la distance e1 entre plots sont choisis de telle façon que chaque plot fasse écran entre le flux incident 10 et le plot suivant (dans le sens du flux), afin qu'il y ait ou non, selon le résultat désiré, continuité entre le dépôt formé sur le flanc de chaque plot et le dépôt formé au fond de la tranchée 12 qui sépare ce plot du plot suivant (cette tranchée 12 étant parallèle à l'axe y et séparant deux lignes de plots). Trois des quatre flancs de chaque plot ainsi que la partie de tranchée située derrière chaque plot (observé dans le sens du flux 10) sont ainsi protégés et ne reçoivent pas de dépôt.
   Dans le cas de la figure 2A, l'angle d'incidence α est suffisamment petit, compte tenu de la distance entre plots et de la hauteur de ceux-ci, pour qu'il y ait continuité entre le dépôt 14 formé sur le flanc d'un plot et le dépôt 16 formé au fond de la tranchée 12 adjacente.
   Dans le cas de la figure 2B, l'angle d'incidence, noté β, est plus grand et conduit à une non-continuité des deux dépôts 14 et 16, le dépôt n'apparaissant pas sur la figure 2B à cause de l'ombrage apporté par le plot adjacent. Il convient de noter qu'il y a toujours un dépôt dans les tranchées qui sont parallèles à l'axe x et séparent donc les colonnes de plots les unes des autres.
5) Le flux incident 10 est composé d'atomes d'un matériau magnétique (principalement le fer, le cobalt, le nickel ou les alliages de ces derniers), et contenant éventuellement d'autres éléments introduits en quantité variable (par exemple le chrome, le tantale, le platine, le molybdène et le terbium) afin d'ajuster les propriétés magnétiques du dépôt.
6) On obtient donc trois dépôts différents:
   - un dépôt magnétique 18 sur le dessus des plots 2 (de forme quelconque, par exemple sensiblement carrée ou rectangulaire parallèlement au plan (x, y), ou sensiblement ronde ou elliptique comme cela est également indiqué plus loin)
   - un dépôt magnétique 14 sur l'un des flancs du plot (de forme carrée ou rectangulaire parallèlement au plan (y, z)), et
   - un dépôt magnétique non représenté dans les tranchées parallèles au plan (x, z).
7) On neutralise le signal magnétique émanant du dessus des plots et du fond des tranchées qui sont parallèles à l'axe x par l'un des moyens (A), (B) et (C) qui sont détaillés ci-dessous.
   (A) Si le réseau de plots est formé par un procédé classique de nano-lithographie (comprenant l'insolation d'une résine photosensible puis une abrasion ionique sélective), on conserve, à la fin du processus de fabrication des plots, le film de résine photosensible 20 ayant servi de masque sur le dessus des plots. Après le dépôt du matériau magnétique, un solvant permet d'enlever la résine photosensible et le dépôt magnétique 18 formé sur le dessus des plots.
      Le dépôt de matériau magnétique dans le fond des tranchées qui sont parallèles à l'axe x n'est pas gênant car il donne un signal magnétique beaucoup plus faible, étant donné son éloignement du sommet des plots. De plus, ce dépôt a la forme de lignes parallèles continues (c'est-à-dire très longues devant la taille des plots) et rayonne donc un champ magnétique beaucoup plus faible que celui du dépôt formé sur le flanc des plots.
      Ce dépôt formé au fond des tranchées est en outre avantageusement utilisable pour canaliser les lignes de champ magnétique émanant d'un plot donné, ce qui permet de ne pas perturber l'état d'aimantation des plots voisins lors des processus d'écriture.
      Si l'on désire que ce dépôt formé au fond des tranchées ait une coercitivité différente de celle du dépôt formé sur le flanc des plots, on peut déposer, en même temps que le matériau magnétique mentionné précédemment, un autre matériau sous une incidence normale (flux 22 sur les figures 2A et 2B) ou sous une incidence oblique (flux 24 sur les figures 2A et 2B) mais opposée à celle du flux 10 : sur les figures 2A et 2B, le flux 24 est parallèle au plan (x, z) mais fait un angle -α (figure 2A) ou -β (figure 2B) avec l'axe z.
      Suivant la nature et la vitesse de dépôt de cet autre matériau, on peut faire varier la coercitivité de l'alliage déposé au fond des tranchées, cet alliage résultant du dépôt simultané des deux matériaux.
   (B) Après avoir formé le dépôt de matériau magnétique (flux 10 des figures 2A et 2B), on effectue une abrasion ionique sous une incidence oblique et opposée à celle qui est utilisée pour former ce dépôt, cette abrasion ionique ayant donc lieu suivant la flèche 24 des figures 2A et 2B.
      Cela permet d'enlever le matériau magnétique déposé sur le dessus des plots et au fond des tranchées parallèles à l'axe x sans perturber le dépôt formé sur le flanc des plots.
   (C) On dépose, en même temps que le matériau magnétique, un matériau non magnétique, par exemple le chrome, sous une incidence normale au plan du réseau de plots (flèche 22 des figures 2A et 2B) ou sous une incidence oblique et opposée à celle du flux 10 et donc suivant la flèche 24 des figures 2A et 2B. Le matériau magnétique forme ainsi un alliage avec le matériau non magnétique sur le dessus des plots et au fond des tranchées parallèles à l'axe x, la quantité de matière déposée sur les flancs des plots étant négligeable dans le cas d'une incidence normale au plan du réseau de plots.

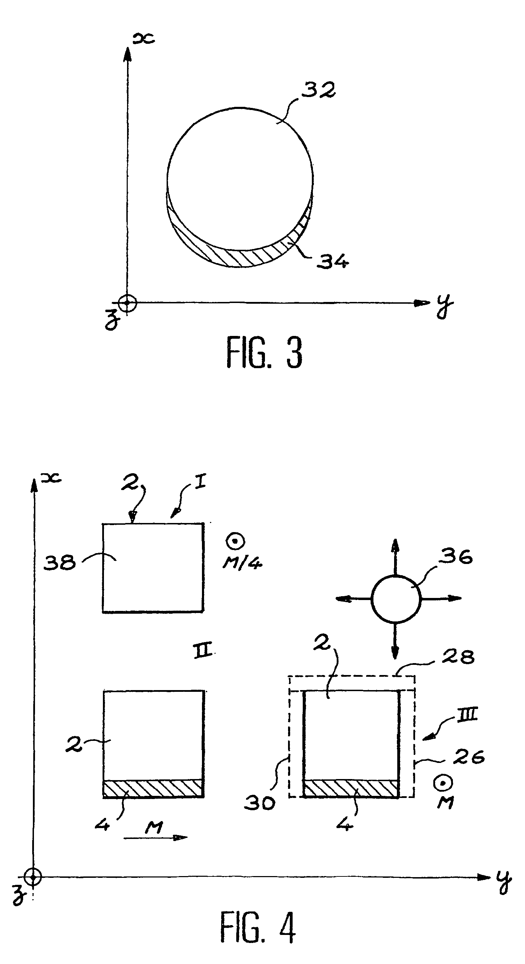

   La vitesse de dépôt et la nature du matériau non magnétique sont choisies de telle façon que l'alliage formé soit lui-même non magnétique.
   On peut également, (1) avec les procédés (A) et (C), effectuer une pluralité de dépôts successifs et tourner le réseau de plots de 90° ou 180° dans son plan entre deux dépôts successifs.
   A titre d'exemple, dans le cas (A), on peut faire un premier dépôt de matériau magnétique puis tourner le réseau puis faire un deuxième dépôt de l'autre matériau et, dans le cas (C), on peut faire un premier dépôt de matériau magnétique puis tourner le réseau puis faire un deuxième dépôt de matériau non magnétique. On peut ensuite tourner à nouveau le réseau puis faire le premier dépôt puis tourner le réseau puis faire le deuxième dépôt et ainsi de suite.
   On peut également, (2) avec le procédé (A), utiliser une pluralité de flux d'atomes de matériaux magnétiques sous incidence oblique.
   Dans les cas (1) et (2) ci-dessus, on réalise alors des dépôts magnétiques sur plusieurs flancs du plot, ce qui augmente la densité d'information.
   Ceci est schématiquement illustré en vue de dessus sur la figure 4 où l'on voit un plot 2 dont un flanc est pourvu du dépôt magnétique 4 et dont les autres flancs sont respectivement pourvus de dépôts magnétiques 26, 28 et 30.
8) On induit un axe facile d'anisotropie magnétique dans le dépôt vertical 14 sur le flanc de chacun des plots, cet axe pouvant être dirigé soit parallèlement au plan du réseau de plots, c'est-à-dire suivant l'axe y, soit perpendiculairement à ce plan c'est-à-dire suivant l'axe z.
   Ceci peut être réalisé soit en formant le dépôt de matériau magnétique sur les plots en présence d'un champ magnétique extérieur orienté suivant l'un des axes y et z, soit en effectuant après ce dépôt un traitement thermique en présence d'un tel champ magnétique.
   Si l'on utilise des plots à section transversale circulaire ou elliptique (section perpendiculaire à l'axe z), une anisotropie magnétique perpendiculaire, c'est-à-dire suivant l'axe z, est favorisée par le gradient latéral d'épaisseur résultant de la géométrie de dépôt utilisée.
   La figure 3 est une vue schématique de dessus, c'est-à-dire suivant l'axe z, d'un plot 32 à section circulaire. Le dépôt de matériau magnétique formé sur le flanc de ce plot, sous incidence oblique, parallèlement au plan (x, z), a la référence 34.
   Un support de stockage d'informations conforme à l'invention pourrait donc comprendre un réseau de plots du genre du plot 32, formés sur un même substrat, le plan du réseau étant le plan (x, y).
9) Si l'axe facile d'anisotropie magnétique est perpendiculaire au plan du réseau de plots, on obtient l'équivalent d'un matériau à anisotropie magnétique perpendiculaire puisque le matériau magnétique à anisotropie planaire (cas du fer, du cobalt, du nickel ou leurs alliages en couches minces) a été déposé sur le flanc des plots, flanc qui est perpendiculaire au plan du réseau.

L'invention présente divers avantages par rapport aux matériaux classiques à anisotropie perpendiculaire, par exemple les alliages ordonnés tels que CoPt et FePt ou les multicouches telles que Co/Pt et Fe/Pt :
- Il est très facile de former le dépôt latéral de matériau magnétique (il s'agit en effet d'une couche unique de matériau magnétique), contrairement à la fabrication d'un alliage ordonné, épitaxié sur un substrat monocristallin, ou d'une multicouche comprenant des couches dont l'épaisseur vaut une fraction de nanomètre. De plus, on peut utiliser tous les matériaux magnétiques à aimantation planaire actuellement employés pour la fabrication de supports de stockage d'informations.
- Ce dépôt de matériau magnétique a une grande stabilité thermique comparativement à celle de multicouches composées de très fines couches de cobalt, nickel, fer, palladium et/ou platine : il ne risque pas de se produire une interdiffusion des éléments, conduisant à la perte des propriétés magnétiques. Cette grande stabilité thermique rend la structure du support objet de l'invention compatible avec les procédés technologiques existants et permet également d'envisager des traitements thermiques sous champ magnétique à haute température afin d'induire un axe d'anisotropie magnétique dans les dépôts formés sur les plots d'un support conforme à l'invention ou de modifier les propriétés magnétiques de ces dépôts.
- L'épaisseur totale du matériau déposé sur un plot peut être beaucoup plus grande que dans le cas des multicouches à aimantation perpendiculaire.
- Le signal magnétique engendré par le dépôt magnétique latéral est plus intense que celui qui est engendré par un alliage ou par une multicouche d'épaisseur totale équivalente car, dans la présente invention, il est possible d'utiliser des alliages magnétiques à forte aimantation, qui ne présentent pas d'anisotropie magnétique perpendiculaire.
- Ce signal magnétique dépend beaucoup moins de la taille des plots : pour un dépôt formé sur la surface horizontale d'un plot carré, une réduction d'un facteur 2 de la taille latérale du plot conduit à une réduction d'un facteur 4 du volume magnétique tandis que, pour un dépôt formé sur le flanc de ce plot, ce facteur de réduction est seulement égal à 2.
- Ce signal magnétique est beaucoup plus localisé sur le réseau de plots : pour un dépôt magnétique de 10 nm d'épaisseur formé sur le flanc d'un plot à section transversale carrée, de 200 nm de côté, la surface horizontale occupée par ce dépôt est vingt fois plus faible que celle du même dépôt, formé sur le sommet du plot. Ceci permet de diminuer les éventuelles interactions magnétiques, à densité d'information constante par rapport à un dépôt sur le sommet des plots, ou inversement d'augmenter la densité d'information, pour des interactions magnétiques équivalentes.

A titre purement indicatif et nullement limitatif, considérons un plot de hauteur h (en nm) de section carrée, de côté L (en nm). On suppose que l'aimantation de la couche magnétique latérale que comporte ce plot est dirigée suivant l'axe z et l'on assimile cette couche magnétique à un dipôle magnétique.

Dans le cas d'un dépôt magnétique d'épaisseur t (en nm) formé sur le flanc du plot, le volume magnétique vaut L x h x t nm³, pour une surface horizontale de L x t nm², d'où une densité magnétique (quantité d'aimantation par unité de surface) égale à h (en unités arbitraires).

Si l'on compare ce dépôt latéral à un dépôt classique de t nm d'une multicouche (CO_{0,5nm}/Pt_{1,5nm})_{t/2} formée sur le sommet du même plot, le volume magnétique est de l'ordre de 0,5 x t/2 x L x L nm³, pour une surface horizontale de L x L nm², d'où une densité magnétique de t/4. Le gain obtenu est donc égal à 4h/t.

Le gain en signal est quant à lui proportionnel à la quantité de matériau magnétique et vaut donc 4 dans cet exemple où les deux dépôts considérés ont la même épaisseur mais où la multicouche contient quatre fois moins de cobalt que la couche unique.

En résumé, la présente invention permet d'avoir un signal magnétique beaucoup plus intense et ce, sur une surface latérale beaucoup plus faible. Ceci est d'autant plus vrai que, dans le cas d'une multicouche (co_{1/4}/Pt_{3/4}), l'aimantation de telles couches de cobalt, d'une fraction de nanomètre d'épaisseur, est plus faible que celle du cobalt massif à cause, d'une part, de la réduction du moment magnétique que l'on observe généralement dans les couches ultra-minces (il y a formation d'un alliage d'interface) et, d'autre part, de la réduction de la température d'ordre magnétique.

Si l'axe facile d'anisotropie magnétique est parallèle au plan du réseau de plots, il n'y a pas de gain de quantité de signal étant donné que la même couche magnétique est déposée soit sur le sommet soit sur le flanc de chacun des plots du réseau et le gain de localisation que l'on obtient est de l'ordre de h/t par rapport à un matériau classique ayant une anisotropie planaire.

D'une manière plus quantitative et en se référant à la figure 4, si l'on connaît le volume et l'aimantation par unité de volume du dépôt, la valeur de sa surface comptée parallèlement au plan (x, y) du réseau de plots et la hauteur de vol d'une tête de lecture 36 supposée ponctuelle, qui se déplace à l'aplomb du dépôt magnétique, suivant l'axe y pour les cas I et II et suivant l'axe y ou l'axe x pour le cas III, on peut calculer la composante Hz, suivant l'axe z, du champ magnétique rayonné par chaque plot au-dessus du réseau de plots pour différentes géométries de dépôt :
(I) dépôt, sur le sommet des plots 2, d'une multicouche magnétique 38 de 10 nm d'épaisseur, à aimantation perpendiculaire d'intensité M/4, dirigée suivant l'axe z,
(II) dépôt, sur le flanc des plots 2, d'une couche magnétique 4 de 10 nm d'épaisseur, à aimantation planaire d'intensité M, dirigée suivant l'axe y,
(III) dépôt sur le flanc des plots 2, d'une couche magnétique 4 de 10 nm d'épaisseur, à aimantation planaire d'intensité M, dirigée suivant l'axe z.

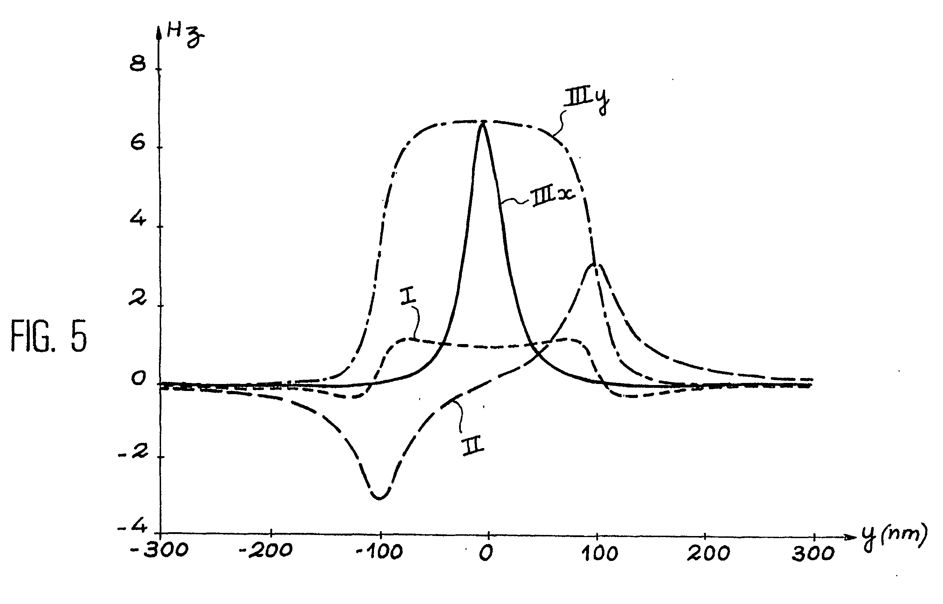

La figure 5 permet de comparer les variations de Hz (en unités arbitraires) en fonction de la distance y (en nm) au centre du plot (comptée parallèlement à l'axe y), pour un champ magnétique rayonné à une distance de 20 nm au-dessus de la surface du plot supposé cubique, de 200 nm de côté, dans ces trois cas (I) à (III), le déplacement de la tête de lecture 36 s'effectuant suivant l'axe y pour les cas (I) et (II) et suivant l'axe y ou l'axe x pour le cas (III).

Les courbes I, II, IIIy et IIIx de la figure 5 correspondent respectivement au cas I, au cas II, au cas III avec un déplacement suivant l'axe y et au cas III avec un déplacement suivant l'axe x.

On constate que, par rapport au cas (I) de la multicouche à aimantation perpendiculaire, la valeur de Hz est environ 3 fois plus forte dans le cas (II) du dépôt sur le flanc du plot avec une aimantation dirigée suivant l'axe y, et environ 7 fois plus forte dans le cas (III) du dépôt sur le flanc du plot avec une aimantation dirigée suivant l'axe z.

De plus, on constate que si le déplacement de la tête de lecture s'effectue suivant l'axe x dans le cas (III), l'extension spatiale du signal est beaucoup plus faible que dans le cas d'un déplacement suivant l'axe y (la largeur à mi-hauteur du signal est environ 5 fois plus faible), ce qui entraîne une bien meilleure séparation des signaux émanant des différents plots et conduit également à une diminution du couplage magnétostatique entre plots.

Après avoir formé le dépôt de matériau magnétique sur le flanc des plots du réseau, il est possible de former une couche protectrice, par exemple en silice, sur toute la surface du réseau de plots puis de planer (on dit aussi planariser) cette surface afin d'éliminer tout relief.

Il convient de noter que, dans la présente invention, les plots peuvent avoir n'importe quelle forme; ils peuvent avoir, par exemple, une section carrée, triangulaire, elliptique ou ronde.

De plus, chaque plot peut contenir un domaine magnétique ou une pluralité de domaines magnétiques. A titre d'exemple, avec un plot de section carrée, il est possible d'obtenir quatre domaines magnétiques. Mais il faut que les domaines magnétiques soient séparés.

En outre, en revenant au (point 8) considéré plus haut, on précise que, dans l'invention, une autre manière d'induire un axe d'amisotropie magnétique dans le plan de la couche mince est d'effectuer un dépôt d'une couche d'un matériau antiferromagnétique au-dessus ou au-dessous de la couche mince. Cette couche antiferromagnétique est par exemple en NiO, en FeMn ou en PtMn. A titre d'exemple, cette couche peut avoir quelques nanomètres d'épaisseur.

## Revendications

1. Support de stockage d'informations, comprenant un réseau de plots (2, 32) de dimensions submicroniques, ce réseau étant formé sur un substrat (8), chaque plot contenant au moins un domaine magnétique qui a une direction d'aimantation (M) et correspond à un bit défini par cette direction d'aimantation; ce domaine magnétique étant formé par une couche a mince (4, 34) d'au moins un matériau magnétique qui recouvre latéralement ce plot, ce support étant **caractérisé en ce que** ces plots, dans lesquels le matériau magnétique au sommet des plots et au fond des tranchées séparant les rangées de plots a des propriétés magnétiques localement modifiées

2. Support selon la revendication 1, dans lequel la direction d'aimantation (M) est perpendiculaire au plan du réseau de plots.

3. Procédé de fabrication du support de stockage d'informations selon l'une quelconque des revendications 1 et 2, dans lequel on dépose le matériau magnétique sur les plots (2, 32) en envoyant sur ces derniers un premier flux (10) d'atomes de ce matériau sous une incidence oblique par rapport à la normale au plan du réseau, chaque plot faisant ombrage au plot qui le suit dans le sens du premier flux, et l'on neutralise le signal magnétique résultant du matériau magnétique déposé au sommet des plots et au fond des tranchées séparant des rangées de plots en modifiant localement les propriétés magnétiques dudit materiau magnétique au sommet des plots et au fond des tranchées séparant les rangées de plots.

4. procédé selon la revendication 3, dans lequel le matériau magnétique est un matériau choisi dans le groupe comprenant le fer, le nickel, le cobalt, les alliages de ces derniers et les matériaux magnétiques à forte aimantation, ou l'un des matériaux de ce groupe, auquel on ajoute un ou une pluralité d'autres éléments, en quantité variable, ces éléments permettant d'ajuster les propriétés magnétiques de la couche mince.

5. Procédé selon l'une quelconque des revendications 3 et 4, dans lequel une résine (20) recouvre le sommet des plots avant le dépôt du matériau magnétique et l'on élimine cette résine après avoir déposé ce matériau magnétique, pour obtenir ainsi un premier dépôt sur les flancs des plots.

6. Procédé selon la revendication 5, dans lequel on envoie sur le réseau de plots (2) un deuxième flux d'atomes d'un matériau de neutralisation en même temps que l'on envoie le premier flux et sous une incidence normale au plan du réseau ou sous une incidence oblique par rapport à la normale (z) au plan du réseau, avec un angle d'incidence opposé à celui du premier flux par rapport à cette normale, l'intensité du deuxième flux et le matériau de neutralisation étant choisis pour que l'alliage ainsi formé au fond des tranchées avec le matériau magnétique ait des propriétés magnétiques différentes de celles du premier dépôt obtenu sur les flancs des plots.

7. Procédé selon l'une quelconque des revendications 3 à 6, dans lequel on envoie le premier flux et au moins un deuxième flux d'atomes d'un matériau magnétique sur les plots (2), sous des incidences obliques par rapport à la normale (z) au plan du réseau, pour former des dépôts magnétiques (4, 26, 28, 30) sur une pluralité de flancs de chaque plot.

8. Procédé selon l'une quelconque des revendications 3 et 4, dans lequel on élimine le matériau magnétique déposé sur le sommet des plots et au fond des tranchées, cette élimination résultant par exemple d'une abrasion ionique sous une incidence oblique par rapport à la normale (z) au plan du réseau, avec un angle d'incidence opposé à celui du premier flux.

9. Procédé selon l'une quelconque des revendications 3 et 4, dans lequel on envoie un deuxième flux d'atomes, en même temps que le premier flux, sous un incidence oblique par rapport au plan du réseau, avec un angle d'incidence opposé à celui du premier flux, l'intensité et la nature des atomes du deuxième flux étant aptes à conduire, avec le premier flux, à la formation d'un alliage non magnétique au sommet des plots et au fond des tranchées.

10. Procédé selon la revendication 9, dans lequel, après avoir déposé les atomes des premier et deuxième flux,
- on intervertit ces premier et deuxième flux et l'on envoie les flux ainsi intervertis sur les plots ou
- on fait tourner le réseau de 180° autour de la normale (z) au plan du réseau et l'on envoie à nouveau les premier et deuxième flux,
afin d'obtenir un dépôt des atomes des premier et deuxième flux sur deux flancs opposés de chaque plot.

11. Procédé selon l'une quelconque des revendications 3 à 10, dans lequel
- on forme la couche mince en présence d'un champ magnétique extérieur ou
- après avoir formé la couche mince, on traite thermiquement cette couche mince en présence d'un champ magnétique extérieur, ou
- on effectue un dépôt d'une couche d'un matériau antiferromagnétique au-dessus ou au-dessous de la couche mince,
afin d'induire un axe d'anisotropie magnétique dans le plan de cette couche mince.

12. Procédé selon l'une quelconque des revendication 3 à 11, dans lequel les plots (32) ont une section transversale circulaire ou elliptique parallèlement au plan du réseau, la couche (34) mince formée latéralement sur chaque plot ayant ainsi un gradient latéral d'épaisseur, et l'on utilise ce gradient pour induire un axe d'anisotropie magnétique perpendiculaire au plan du réseau.

13. Procédé selon l'une quelconque des revendications 3 à 12, dans lequel on forme en outre une couche protectrice sur toute la surface du réseau puis on effectue un planage de cette surface ainsi pourvue de la couche protectrice, afin d'éliminer tout relief.

## Claims

1. Information storage medium, comprising an array of dots (2, 32) of submicronic dimensions, said array being formed on a substrate (8), each dot containing at least one magnetic domain which has a direction of magnetisation (M) and corresponds to a bit defined by this direction of magnetisation, said magnetic domain being formed by a thin layer (4, 34) of at least one magnetic material which laterally covers said dot, said medium being **characterized in that** said dots in which the magnetic material at the apex of the dots and at the bottom of the trenches separating rows of dots has locally modified magnetic properties.

2. Medium as claimed in claim 1, wherein the direction of magnetisation (M) is perpendicular to the plane of the array of dots.

3. Process for production of the information storage medium as claimed in either of claims 1 and 2, wherein the magnetic material is deposited on the dots (2, 32) by sending to the latter a first flux (10) of atoms of said material at an oblique incidence relative to the normal to the plane of the array, each dot shadowing the dot following it in the direction of the first flux, and the magnetic signal resulting from the magnetic material deposited on top of the dots and at the base of the trenches separating rows of dots is neutralised by locally modifying the magnetic properties of said magnetic material at the apex of the dots.

4. Process as claimed in claim 3, wherein the magnetic material is a material selected from the group comprising iron, nickel, cobalt, alloys of the latter and magnetic materials with strong magnetisation, or one of the materials of said group, to which is added one or a plurality of other elements, in variable quantity, these elements enabling the magnetic properties of the thin layer to be adjusted.

5. Process as claimed in either of claims 3 and 4, wherein a resin (20) covers the top of the dots before the magnetic material is deposited and this resin is eliminated after said magnetic material has been deposited, to thus obtain a first deposit on the sides of the dots.

6. Process as claimed in claim 5, wherein a second flux of atoms of a neutralisation material is sent to the array of dots (2) at the same time as the first flux is sent and at a normal incidence to the plane of the array or at an oblique incidence relative to the normal (z) to the plane of the array, with an angle of incidence opposite that of the first flux relative to this normal, the intensity of the second flux and the neutralisation material being selected so that the alloy thus formed at the base of the trenches with the magnetic material has magnetic properties different to those of the first deposit obtained on the sides of the dots.

7. Process as claimed in either of claims 3 to 6, wherein the first flux and at least a second flux of atoms of a magnetic material is sent to the dots (2), at oblique incidences relative to the normal (z) to the plane of the array, to form magnetic deposits (4, 26, 28, 30) on a plurality of sides of each dot.

8. Process as claimed in either of claims 3 and 4, wherein the magnetic material deposited on the top of the dots and at the base of the trenches is eliminated, said elimination resulting for example from an ionic abrasion at an oblique incidence relative to the normal (z) to the plane of the array, with an angle of incidence opposite to that of the first flux.

9. Process as claimed in either of claims 3 and 4, wherein a second flux of atoms is sent, at the same time as the first flux, at an oblique incidence relative to the plane of the array, with an angle of incidence opposite to that of the first flux, the intensity and the nature of the atoms of the second flux being capable of resulting, with the first flux, in formation of a non-magnetic alloy on the top of the dots and at the base of the trenches.

10. Process as claimed in claim 9, wherein, after the atoms of the first and second flux have been deposited,
- these first and second fluxes are inverted and the fluxes thus inverted are sent to the dots, or
- the array is turned 180° around the normal to the plane of the array and the first and second fluxes are again sent,
in order to obtain deposit of the atoms of the first and second fluxes on two opposite sides of each dot.

11. Process as claimed in any one of claims 3 to 10, wherein
- the thin layer is formed in the presence of an external magnetic field, or
- after forming the thin layer, this thin layer is thermally treated in the presence of an external magnetic field, or
- a deposit of a layer of an antiferromagnetic material is made above or below the thin layer,
so as to induce an axis of magnetic anisotropy in the plane of this thin layer.

12. Process as claimed in any one of claims 3 to 11, wherein the dots (32) are transverse, circular or elliptical in section parallel to the plane of the array, the thin layer (34) formed laterally on each dot thus having a lateral gradient in thickness, and said gradient is used to induce an axis of magnetic anisotropy perpendicular to the plane of the array.

13. Process as claimed in any one of claims 3 to 12, wherein a protective layer is also formed on the entire surface of the array, then this surface thus provided with the protective layer is planarized in order to eliminate any relief.

## Patentansprüche

1. Datenträger mit einem Gitter von Kontaktstellen (2, 32) mit submikrometrischen Abmessungen, wobei dieses Gitter auf einem Substrat (8) ausgebildet ist, jede Kontaktstelle wenigstens einen magnetischen Bereich umfasst, der eine Magnetisierungsrichtung (M) aufweist und einem durch diese Magnetisierungsrichtung definierten Bit entspricht, und dieser magnetische Bereich durch eine dünne, die Kontaktstelle seitlich bedeckende Schicht (4, 34) aus wenigstens einem magnetischen Material gebildet wird, wobei dieser Träger dabei
**dadurch gekennzeichnet ist, dass** das magnetische Material auf der Oberseite dieser Kontaktstellen und auf dem Boden der die Kontaktstellenreihen trennenden Gräben lokal modifizierte magnetische Eigenschaften aufweist:

2. Träger nach Anspruch 1, bei dem die Magnetisierungsrichtung (M) zur Ebene des Kontaktstellengitters senkrecht ist.

3. Verfahren zur Herstellung des Datenträgers nach einem der Ansprüche 1 und 2, bei dem man das magnetische Material auf den Kontaktstellen (2, 32) abscheidet, indem man diese Letzteren einem ersten Fluss (10) von Atomen dieses Materials unter einem in Bezug auf die Gitterebenen-Normale schrägen Einfallwinkel aussetzt, wobei jede Kontaktstelle die in der Richtung des ersten Flusses auf sie folgende beschattet, und man das magnetische Signal neutralisiert, das aus dem auf der Oberseite der Kontaktstellen und auf dem Boden der die Kontaktstellenreihen trennenden Gräben abgeschiedenen magnetischen Material resultiert, indem man die magnetischen Eigenschaften des genannten magnetischen Materials auf der Oberseite und auf dem Boden der die Kontaktstellenreihen trennenden Gräben lokal modifiziert.

4. Verfahren nach Anspruch 3, bei dem das magnetische Material ein aus der Gruppe ausgewähltes Material ist, die Eisen, Nickel, Kobalt, die Legierungen dieser Letzteren und die magnetischen Materialien mit starker Magnetisierung umfasst, oder eines der Materialien dieser Gruppe ist, dem man ein anderes oder eine Vielzahl anderer Elemente in variabler Quantität zusetzt, wobei diese Elemente ermöglichen, die magnetischen Eigenschaften der dünnen Schicht anzupassen.

5. Verfahren nach einem der Ansprüche 3 und 4, bei dem ein Resist (20) die Oberseite der Kontaktstellen vor der Abscheidung des magnetischen Materials bedeckt und man dieses Resist eliminiert, nachdem man dieses magnetische Material abgeschieden hat, um auf diese Weise eine erste Abscheidung auf den Flanken der Kontaktstellen zu erhalten.

6. Verfahren nach Anspruch 5, bei dem man das Gitter aus Kontaktstellen (2) einem zweiten Fluss von Atomen unter einem in Bezug auf die Gitterebenen-Normale (z) schrägen Einfallwinkel aussetzt, wobei dieser Einfallwinkel in Bezug auf diese Normale dem Einfallwinkel des ersten Flusses entgegengesetzt ist, und die Intensität des zweiten Flusses und das Neutralisierungsmaterial so gewählt werden, dass die derart auf dem Boden der Gräben mit dem magnetischen Material gebildete Legierung andere magnetische Eigenschaften hat als die der auf den Flanken der Kontaktstellen hergestellten ersten Abscheidung.

7. Verfahren nach einem der Ansprüche 3 bis 6, bei dem man die Kontaktstellen (2) einem ersten Fluss und wenigsten einem zweiten Fluss aussetzt, unter in Bezug auf die Gitterebenen-Normale (z) schrägen Einfallwinkeln, um magnetische Abscheidungen (4, 26, 28, 30) auf einer Mehrzahl der Flanken jeder Kontaktstelle auszubilden.

8. Verfahren nach einem der Ansprüche 3 und 4, bei dem man das auf der Oberseite der Kontaktstellen und auf dem Boden der Gräben abgeschiedene magnetische Material eliminiert, wobei diese Eliminierung zum Beispiel durch Ionen-Abrasion unter einem in Bezug auf die Gitterebenen-Normale (z) schrägen Einfall erfolgt, mit einem zum Einfallwinkel des ersten Flusses entgegengesetzten Einfallwinkel.

9. Verfahren nach einem der Ansprüche 3 und 4, bei dem man gleichzeitig mit dem ersten Atomfluss einen zweiten Atomfluss erzeugt, unter einem in Bezug auf die Gitterebenen-Normale schrägen Einfallwinkel, wobei die Intensität und die Art der Atome des zweiten Flusses fähig sind, zusammen mit dem ersten Fluss auf der Oberseite der Kontaktstellen und dem Boden der Gräben eine unmagnetische Legierung zu bilden.

10. Verfahren nach Anspruch 9, bei dem - nach Abscheidung der Atome des ersten und des zweiten Flusses
- man den ersten und den zweiten Fluss austauscht und die Kontaktstellen dann diesen ausgetauchten Flüssen aussetzt, oder
- man das Gitter um die Gitterebenen-Normale (z) herum um 180° dreht und wieder den ersten und den zweiten Fluss erzeugt,
um eine Abscheidung der Atome des ersten und des zweiten Flusses auf zwei entgegengesetzten Flanken der Kontaktstelle zu erhalten.

11. Verfahren nach einem der Ansprüche 3 bis 10, bei dem
- man die dünne Schicht unter Präsenz eines externen Magnetfelds bildet, oder
- diese dünne Schicht, nachdem man sie gebildet hat, unter Präsenz eines externen Magnetfelds thermisch behandelt, oder
- man über oder unter der dünnen Schicht eine Schicht aus einem antiferromagnetischen Material abscheidet,
um in der Ebene dieser dünnen Schicht eine Achse magnetischer Anisotropie zu induzieren.

12. Verfahren nach einem der Ansprüche 3 bis 11, bei dem die Kontaktstellen (32) parallel zu der Ebene des Gitters einen runden oder elliptischen Querschnitt haben, wobei die seitlich auf jeder Kontaktstelle gebildete dünne Schicht (34) dann einen seitlichen Dickengradienten hat und man diesen Gradienten benutzt, um eine zu der Ebene des Gitters senkrechte Achse magnetischer Anisotropie zu induzieren.

13. Verfahren nach einem der Ansprüche 3 bis 12, bei dem man außerdem auf der gesamten Oberfläche des Gitters eine Schutzschicht bildet und dann diese mit der Schutzschicht versehene Oberfläche planarisiert, um jedes Relief zu eliminieren.
